# EUROPÄISCHE PATENTANMELDUNG

(11) **EP 3 859 792 A1**
(43) Veröffentlichungstag der Anmeldung: **04.08.2021**
(21) Anmeldenummer: 20154804.7
(22) Anmeldetag: 31.01.2020
(51) Int. Cl.: H01L 31/048, H01L 31/042, H02S 40/20, G02F 1/15

(54) **ABDECKUNG FÜR EINE SOLARZELLE MIT ELEKTROCHROMEM FILTER**

(71) Anmelder: Siemens Aktiengesellschaft, 80333 München (DE)
(72) Erfinder: Fleischer, Maximilian, 85635 Höhenkirchen (DE); Pohle, Roland, 85570 Herdweg (DE); Simon, Elfriede, 80639 München (DE); von Sicard, Oliver, 81541 München (DE)

(57) **Zusammenfassung**

Die Erfindung betrifft eine Anordnung (1) umfassend eine Solarzelle (10) und eine Abdeckung (20), wobei die Abdeckung (20) die Solarzelle (10) zumindest auf derjenigen Seite bedeckt, die zur Bestrahlung mit elektromagnetischer Strahlung (2) der Sonne vorgesehen ist. Die Abdeckung (20) weist eine elektrochrome Schicht auf. Die Anordnung (1) weist ferner eine Steuerungseinheit (30) zur Steuerung der elektrochromen Schicht aufweist. Die Steuerungseinheit (30) ist dazu ausgestaltet, durch Anlegen einer elektrischen Spannung an die elektrochrome Schicht den Transmissionsgrad der elektrochromen Schicht für elektromagnetische Strahlung (2) in einem definierten Wellenlängenbereich zu steuern.

## Beschreibung

### Technisches Gebiet

Die Erfindung betrifft eine Anordnung umfassend eine Solarzelle, eine Abdeckung mit einer elektrochromen Schicht aufweist, und eine Steuerungseinheit zur Steuerung der elektrochromen Schicht. Des Weiteren betrifft die Erfindung ein Verfahren zum Betreiben einer solchen Solarzelle.

### Stand der Technik

Perowskit-Solarzellen sind eine neue und vielversprechende Dünnschichttechnologie für die Photovoltaik. Im Labormaßstab wurden bereits Wirkungsgrade von über 25% gezeigt, welches an die Rekordwirkungsgrade von konventionellen multi- oder monokristallinen Silicium-Solarzellen (23% bzw. 26%) herankommt. Für Tandem-Solarzellen bestehend aus einer Perowskit- und einer Silicium-Solarzelle wurde im Labormaßstab bereits ein Wirkungsgrad von 28% gezeigt.

Das Material der Perowskit-Struktur hat die allgemeine Struktur ABX₃. Als photoaktives Material wird typischerweise die Grundform (CH₃NH₃)PbX₃ verwendet. Das photoaktive Material und die aktuell verwendeten Lochleiterschichten haben einige Herausforderungen bezüglich Stabilität hinsichtlich ultravioletter Strahlung (UV-Strahlung), Feuchtebeständigkeit und Temperaturstabilität.

UV-Strahlung kann über photokatalytische Effekte der in den Solarzellen verbauten Materialien (z.B. TiO₂) oder durch direkte Einwirkung der UV-Strahlung auf die vorkommenden Schichten (besonders betroffen sind dabei die organischen Bestandteile) zu einer Schädigung der Zellen und somit einer Absenkung des Wirkungsgrads führen.

Zudem können die Perowskit-Solarzellen bei höheren Temperaturen beschädigt werden und/oder die Effizienz der Zellen sinkt stark ab. Dies kann durch Phasenumwandlungen im Perowskit, durch bei erhöhten Temperaturen verstärkte Diffusion von Schichten ineinander oder durch verstärkte Ionenmigration im Perowskit hervorgerufen werden.

Je nach genauer Zusammensetzung des Perowskits (es können bestimmte Anteile der Struktur durch andere Elemente/Verbindungen ersetzt werden) und Auswahl der Ladungsträgerleiterschichten liegt die kritische Temperatur für die Perowskit-Solarzelle, bei der die Zelle geschädigt wird, unterschiedlich, jedoch üblicherweise im Bereich 55°C bis 90°C.

Es ist daher wichtig, die Temperatur einer Perowskit-Solarzelle unter dieser kritischen Grenze zu halten, um eine Zerstörung der Perowskit-Solarzelle zu verhindern und eine hohe Effizienz dauerhaft zu erhalten.

Die Hauptursache für die Temperaturerhöhung der Perowskit-Solarzellen in einem Photovoltaikmodul ist die Einstrahlung der Sonne. Photonen im niederenergetischen Bereich (unterhalb der Bandlücke des Perowskits) können nicht für die Ladungsträger-Erzeugung genutzt werden, tragen jedoch zur Temperaturerhöhung der Zelle bei. Hochenergetische Photonen (oberhalb der Bandlücke) tragen zur Erzeugung von Elektronen-Loch-Paaren bei, die darüber hinaus verbleibende Energie wird über Thermalisierung an das Material abgegeben.

Vor diesem Hintergrund besteht die Aufgabe der Erfindung darin, das Risiko eines Überhitzens einer Solarzelle, insbesondere einer Perowskit-Solarzelle, mit einhergehender irreversibler Schädigung der Solarzelle zu minimieren.

### Allgemeine Beschreibung der Erfindung

Diese Aufgabe wird durch eine Anordnung und ein Betriebsverfahren gemäß den unabhängigen Ansprüchen gelöst. Vorteilhafte Weiterführungen und Ausbildungsformen sind in den abhängigen Ansprüchen, der Beschreibung und den Abbildungen offenbart.

Demgemäß wird eine Anordnung umfassend eine Solarzelle und eine Abdeckung vorgeschlagen. Die Abdeckung dient insbesondere dem Schutz der Solarzelle gegen Witterungseinflüsse, beispielsweise Verschmutzung und Hagel. Die Abdeckung bedeckt die Solarzelle zumindest auf derjenigen Seite, die zur Bestrahlung mit elektromagnetischer Strahlung der Sonne vorgesehen ist. Die Abdeckung weist erfindungsgemäß eine elektrochrome Schicht auf. Die Anordnung weist ferner eine Steuerungseinheit zur Steuerung der elektrochromen Schicht auf. Die Steuerungseinheit ist dabei dazu ausgestaltet, durch Anlegen einer elektrischen Spannung an die elektrochrome Schicht den Transmissionsgrad der elektrochromen Schicht für elektromagnetische Strahlung in einem definierten Wellenlängenbereich zu steuern.

Der Kern der Erfindung besteht darin, mittels eines "schaltbaren optischen Filters", der einen Teil der Abdeckung der Solarzelle darstellt, eine Überhitzung der Solarzelle zu vermeiden. Dieser schaltbare Filter wird erfindungsgemäß durch eine elektrochrome Schicht in der Abdeckung realisiert. Unter einer elektrochromen Schicht wird eine Schicht verstanden, die Moleküle bzw. Kristalle aufweist, die ihre optischen Eigenschaften durch ein äußeres elektrisches Feld oder einen Stromfluss ändern. Die Änderung der optischen Eigenschaften basiert allgemein auf einer Änderung von Elektronenzuständen in den Molekülen/Kristallen. Typischerweise können starke elektrochrome Effekte bei einigen Übergangsmetalloxiden (z.B. Wolframoxid), Komplexverbindungen (z.B. "Berliner Blau") und bei einigen leitfähigen Polymeren beobachtet werden. Bei leitfähigen Polymeren kann beispielsweise das Polymergerüst reversibel elektrochemisch oxidiert und reduziert werden.

In Abhängigkeit von dem angelegten elektrischen Feld bzw. dem induzierten Stromfluss ist die Transmission von elektromagnetischer Strahlung durch die elektrochrome Schicht hindurch in einem gewissen Wellenlängenbereich höher oder niedriger. In anderen Worten wird der Transmissionsgrad der Abdeckung, d.h. dessen optische Durchlässigkeit, mittels der in der Abdeckung enthaltenen elektrochromen Schicht gezielt eingestellt. Diese Einstellung wird erfindungsgemäß von einer Steuereinrichtung gesteuert. Dabei ist sowohl ein diskretes wie auch ein stufenloses Variieren des Transmissionsgrads der elektrochromen Schicht denkbar.

In einer Ausführungsform der Erfindung ist die Steuerungseinheit so ausgestaltet, dass sie dazu imstande ist, die Transmission von Photonen, die eine Energie aufweisen, die mehr als ein vorbestimmter Wert über der Aktivierungsenergie der Solarzelle liegt, zumindest zu reduzieren, wenn nicht gar im Wesentlichen zu unterdrücken.

Diese Ausgestaltung zielt auf die Reduzierung bzw. die Unterdrückung hochenergetischer Photonen, worunter Photonen mit einer Energie, die größer als die Bandlücke der verwendeten Solarzelle ist, verstanden werden. Zwar tragen diese hochenergetischen Photonen zur Erzeugung von Elektronen-Loch-Paaren im Absorber des Solarzelle bei, die darüber hinaus verbleibende Energie wird jedoch über Thermalisierung an den Absorber oder angrenzende Schichten der Solarzelle abgegeben. Wird der Transmissionsgrad für hochenergetische Photonen mittels der elektrochromen Schicht also so eingestellt, dass diese weitgehend von der Abdeckung absorbiert oder reflektiert werden und somit die Solarzelle selbst nicht erreichen, sinkt zwar die Generation von Elektron-Loch-Paaren im Absorber der Solarzelle, aber es wird auch ein Aufheizen der Solarzelle vermieden. Unter Umständen kann es vorteilhaft sein, etwas weniger elektrische Leistung der Solarzelle zu entnehmen, aber dafür das Risiko einer irreversiblen Schädigung der Solarzelle aufgrund Überhitzung zu vermindern.

Umgekehrt ist in einer anderen Ausführungsform der Erfindung die Steuerungseinheit so ausgestaltet, dass sie dazu imstande ist, die Transmission von Photonen, die eine Energie aufweisen, die mehr als ein vorbestimmter Wert unter der Aktivierungsenergie der Solarzelle liegt, zumindest zu reduzieren, wenn nicht gar im Wesentlichen zu unterdrücken.

Diese Ausgestaltung zielt auf die Reduzierung bzw. die Unterdrückung niederenergetischer Photonen ab, worunter Photonen mit einer Energie, die kleiner als die Bandlücke der Solarzelle ist, verstanden werden. Photonen im niederenergetischen Bereich können nicht für die Ladungsträger-Erzeugung genutzt werden, tragen jedoch zur Temperaturerhöhung der Zelle bei. Ein Unterdrücken oder Reduzieren der Transmission von Photonen mit einer Energie unterhalb der Bandlücke der Solarzelle erscheint generell vorteilhaft.

Der vorbestimmte Wert über bzw. unter der Aktivierungsenergie der Solarzelle kann z.B. 5%, 10%, 15%, 20%, 25% oder 50% der Aktivierungsenergie betragen. Beträgt die Aktivierungsenergie der Solarzelle z.B. 1,11 eV, würde der vorbestimmte Wert also 0,056 eV, 0,111 eV, 0,167 eV, 0,222 eV bzw. 0,555 eV betragen. Die Transmission von Photonen mit einer Energie von 0,056 eV, 0,111 eV, 0,167 eV, 0,222 eV bzw. 0,555 eV ober- bzw. unterhalb der Aktivierungsenergie (von 1,11 eV) würden dann mittels der Abdeckung mit der elektrochromen Schicht reduziert oder sogar im Wesentlichen komplett unterdrückt.

Die Transmission von Photonen ober- bzw. unterhalb der Aktivierungsenergie gilt dann als "im Wesentlichen" unterdrückt, wenn höchstens 10%, vorzugsweise höchstens 5%, am meisten bevorzugt höchstens 2% der Photonen mit der genannten Energie die elektrochrome Schicht passieren.

In einer weiteren Ausführungsform der Erfindung ist die Steuerungseinheit so ausgestaltet ist, dass sie imstande ist, jegliche Transmission von elektromagnetischer Strahlung der Sonne durch die elektrochrome Schicht im Wesentlichen zu unterdrücken.

In diesem Fall würde also elektromagnetische Strahlung jeglicher Wellenlänge, die als solare Strahlung auf die Abdeckung trifft, von dieser absorbiert oder reflektiert werden. Nur ein unwesentlicher Teil, insbesondere höchstens 10%, vorzugsweise höchstens 5%, am meisten bevorzugt höchstens 2% der auftreffenden Photonen würden dann die elektrochrome Schicht passieren und potenziell von der Solarzelle absorbiert werden können. Diese Variante ist in gewisser Weise die drastischste Anwendung des optischen Filters. Es kann aber in machen Betriebszuständen, z.B. wenn die Solarzelle eine für ihre Integrität vitale Temperatur bereits überschritten hat, vorteilhaft sein, die Solarzelle komplett abzuschatten und dafür temporär den Verlust jeglicher elektrisch entnehmbarer Leistung aus der Solarzelle in Kauf zu nehmen.

Die Steuerungseinheit verbraucht im Allgemeinen elektrische Energie, um die elektrochrome Schicht steuern zu können und insbesondere um eine Änderung des Transmissionsgrads der Schicht für gewisse Wellenlängen zu erreichen. Oft ist aber elektrische Energie nur für eine Änderung des Transmissionsgrads nötig, nicht aber kontinuierlich zur Erhaltung eines gewissen Zustands der elektrochromen Schicht.

In jedem Fall ist es aber denkbar, dass die elektrische Energie, die die Steuerungseinheit benötigt, von der Solarzelle selbst bereitgestellt wird. Insbesondere dadurch, dass vor allem bei einer drohenden Überhitzung der Solarzelle der Zustand der elektrochromen Schicht geändert werden muss, liegt in der Regel auch genügend elektrische Leistung vor, die teilweise eben für die Steuerung der elektrochromen Schicht verwendet werden kann.

Die vorliegende Erfindung ist generell für alle Typen von Solarzellen anwendbar. Sie erscheint jedoch insbesondere vorteilhaft für sogenannte Perowskit-Solarzellen, also Solarzellen, dessen Absorber eine Perowskit-Struktur aufweisen. Dies liegt daran, dass bei Perowskit-Solarzellen - im Gegensatz beispielsweise zu konventionellen kristallinen Silicium-Solarzellen - schon bei relativ niedrigen Zelltemperaturen im Bereich zwischen 55°C bis 90°C ein markanter Abfall des Wirkungsgrad und eine unter Umständen irreversible Schädigung des Zellmaterials zu beobachten ist. Insofern ist es insbesondere für Perowskit-Solarzellen von höchster Bedeutung, eine Überhitzung der Zelle, insbesondere ihres die Perowskit-Struktur aufweisenden Absorbers, zu vermeiden.

Des Weiteren erscheint die Anwendung der vorliegenden Erfindung insbesondere für Tandemsolarzellen, bzw. allgemein für Mehrfachsolarzellen, vorteilhaft. Unter einer Tandemsolarzelle wird ein Verbund aus zwei Solarzellen aus verschiedenen Materialien verstanden, die übereinandergeschichtet sind. Die dem Licht zugewandte obere Solarzelle absorbiert Licht mit einer vergleichsweise kurzen Wellenlänge (gleichbedeutend mit einer hohen Energie) und lässt langwelligeres Licht hindurch. Auf die zweite, darunter angeordnete Solarzelle trifft derjenige Teil des Spektrums auf, der nicht bereits von der oberen Solarzelle absorbiert wurde. So können grundsätzlich beliebig viele Teil-Solarzellen übereinander angeordnet werden. Zweck dieser Anordnung ist es, den Wirkungsgrad der Umwandlung des Sonnenlichts in elektrischen Strom im Vergleich zu Einfachsolarzellen zu erhöhen. Dies erreicht man einerseits dadurch, dass kurzwelliges (hochenergetisches) Licht in den obersten Teil-Solarzellen eine höhere Spannung erzeugt. Andererseits kann die Absorption im langwelligeren (niederenergetischeren) Spektralbereich durch darunter angeordnete Teil-Solarzellen erweitert werden. Es wird in einer Tandemsolarzelle also sowohl der Absorptionsbereich im Vergleich zu einer Einfachsolarzelle erweitert als auch die Effizienz der Umwandlung im kurzwelligen Spektralbereich erhöht. Neuartige Tandemsolarzellen setzen auf die Kombination einer konventionellen Silicium-Solarzelle als unterer Solarzelle und einer Perowskit-Solarzelle als oberer Solarzelle.

Eine Herausforderung bei Tandemsolarzellen besteht darin, einen möglichst ähnlich großen (oder sogar im Wesentlichen gleich großen) Strom der beiden Teilzellen am Maximum Power Point der Tandemsolarzelle zu erreichen. Dies wird fachsprachlich als "current matching" bezeichnet. Der Hintergrund hierfür ist, dass der Strom der Tandemsolarzelle durch den niedrigeren Strom der beiden Teilzellen begrenzt ist. Hierin liegt ein spezieller Vorteil der Anwendung einer elektrochromen Schicht bei einer Tandemsolarzelle: Ist die elektrochrome Schicht nämlich so ausgestaltet, dass sie in derjenigen Teilzelle mit dem höheren Strom am Maximum Power Point der Tandemsolarzelle einen Teil der elektromagnetischen Strahlung reduziert oder blockiert, geht damit unter Umständen keinerlei Reduktion des Gesamtwirkungsgrads der Tandemsolarzelle einher, jedoch wird die Erwärmung in derjenigen Teilzelle mit dem höheren Strom verringert. In anderen Worten ist die Reduzierung der Strahlung für eine der beiden Solarzellen nicht einmal mit einer geringeren Energieausbeute, sondern nur mit einer geringeren thermischen Belastung verbunden - was unter dem Strich einen Vorteil für die Tandemsolarzelle bedeutet.

Ein Photovoltaikmodul ist typischerweise so aufgebaut, dass die Solarzellen in einer transparenten Kunststoffschicht (Ethylenvinylacetat (EVA) oder Silikongummi) eingebettet sind. Auf der Kunststoffschicht liegt auf derjenigen Seite der Solarzelle, die zur Beleuchtung mit Solarstrahlung vorgesehen ist, typischerweise eine Glasscheibe auf. Die Glasscheibe bedeckt somit die Solarzelle. Die Glasscheibe kann direkt auf der Kunststoffschicht aufliegen. Alternativ können weitere Zwischenschichten zwischen der Kunststoffschicht und der Glasscheiben vorliegen oder es kann bewusst ein Leerraum, der mit Luft, Vakuum oder einem Gas, beispielsweise einem Edelgas, gefüllt ist, vorliegen. Als Glasscheibe wird meist ein sogenanntes Einscheiben-Sicherheitsglas (ESG) auf der zur Sonne gewandten Seite verwendet. Ein Rahmen, z.B. ein Aluminiumprofil-Rahmen, vervollständigt den Aufbau und dient zum Schutz der Glasscheibe bei Transport, Handhabung und Montage sowie für die Befestigung und für die Versteifung des Photovoltaikmoduls.

Die elektrochrome Schicht ist erfindungsgemäß ein Teil der Abdeckung. Weist die Abdeckung eine Glasscheibe auf, kann die elektrochrome Schicht z.B. auf einer Seite der Glasscheibe angebracht sein. Alternativ kann die elektrochrome Schicht schon in der Glasscheibe eingearbeitet sein. Als wiederum weitere Variante sind auch zwei aufeinander gepresste Glasscheiben denkbar, zwischen denen sich die elektrochrome Schicht befindet.

Die Erfindung betrifft neben der Anordnung umfassend die Solarzelle, die Abdeckung mit der elektrochromen Schicht und die Steuerungseinheit zur Steuerung der elektrochromen Schicht auch ein Verfahren zum Betreiben eine Solarzelle. Die Solarzelle ist hierbei mit einer Abdeckung geschützt, wobei die Abdeckung die Solarzelle zumindest auf derjenigen Seite bedeckt, die zur Bestrahlung mit elektromagnetischer Strahlung der Sonne vorgesehen ist. Die Abdeckung weist eine elektrochrome Schicht auf. Das Verfahren umfasst ein Anlegen einer elektrischen Spannung an die elektrochrome Schicht mittels einer Steuerungseinheit, um den Transmissionsgrad der elektrochromen Schicht für elektromagnetische Strahlung in einem definierten Wellenlängenbereich zu steuern.

In einer Ausführungsform des erfindungsgemäßen Verfahrens wird in einem vorherigen Schritt die Temperatur der Solarzelle ermittelt. Die Steuerung des Transmissionsgrads erfolgt vorteilhafterweise dann in Abhängigkeit von der ermittelten Temperatur der Solarzelle.

Die Temperatur der Solarzelle kann zum Beispiel mittels Impedanzspektroskopie ermittelt werden, vor allem dann, wenn es sich bei der Solarzelle um eine Solarzelle mit einem Absorber, der eine Perowskit-Struktur aufweist, handelt (eine solche Solarzelle wird auch als Perowskit-Solarzelle bezeichnet). Wie die Temperatur einer Perowskit-Solarzelle mittels Impedanzspektroskopie ermittelt werden kann, ist beispielsweise in der internationalen Patentanmeldung PCT/EP2019/074317 im Detail beschrieben.

In einer weiteren Ausführungsform der Erfindung verwendet die Steuerungseinrichtung künstliche Intelligenz, um ein Optimum für die Einstellung des Transmissionsgrads der elektrochromen Schicht für bestimmte Wellenlängenbereiche der auftreffenden elektromagnetischen Strahlung zu ermitteln. Die Zielgröße der Optimierung ist insbesondere eine größtmögliche Energieausbeute bei Erhaltung, das heißt, keiner signifikanten Degradation, der Eigenschaften der Solarzelle. Insbesondere bei der Steuerung der Transmission hochenergetischer Photonen muss eine Abwägung getroffen werden, ob eine höhere Energieausbeute durch eine größere Erzeugung von Elektron-Loch-Paaren in der Solarzelle oder ein niedrigeres Risiko für eine (irreversible) Schädigung des Solarzellenmaterials gewählt wird. Hierfür kann ein entsprechend angelerntes neuronales Netz von Nutzen sein.

### Kurze Beschreibung der Zeichnung

Nachfolgend wird die Erfindung anhand der beigefügten Abbildung veranschaulicht.

Die Abbildung zeigt:

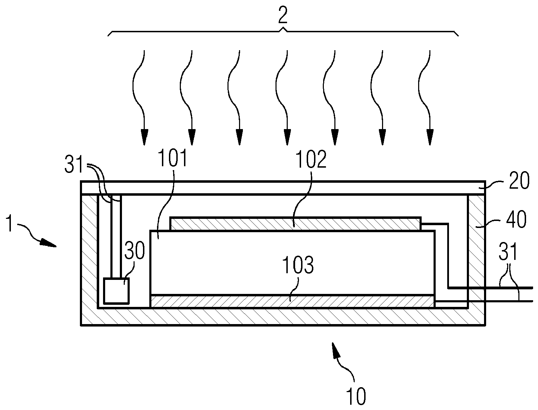

- Fig. 1:: eine Anordnung umfassend eine Solarzelle, eine Abdeckung mit einer elektrochromen Schicht und eine Steuerungseinheit zur Steuerung der elektrochromen Schicht.

### Detaillierte Beschreibung der Zeichnung

Die Abbildung 1 (auch als Fig. 1 bezeichnet) zeigt eine Solarzelle 10 mit einem Absorber 101, einem Vorderseitenkontakt 102 und einem Rückseitenkontakt 103. Bei der Solarzelle 10 kann es sich beispielsweise um eine Perowskit-Solarzelle handeln. Der Absorber 101 zur Absorption elektromagnetischer Strahlung der Sonne (auch als "Solarstrahlung" oder "solare Strahlung" bezeichnet) weist in diesem Fall eine Perowskit-Struktur mit der allgemeinen Strukturformel ABX₃ auf. Konkret hat sich beispielsweise das Material (CH₃NH₃)PbI₃ als geeignetes photoaktives Material erwiesen. Der Vorderseitenkontakt 102 ist für elektromagnetische Strahlung aus einem bestimmten Wellenlängenbereich, für den die Solarzelle konzipiert ist, vorzugsweise transparent. Der Rückseitenkontakt 103 kann vollflächig und nicht transparent ausgestaltet sein (z.B. umfassend eine Aluminiumlegierung). Der Vorderseitenkontakt 102 und Rückseitenkontakt 102 sind jeweils mit elektrischen Leitern 31 verbunden. Befinden sich mehrere Solarzellen in einem Photovoltaikmodul (was in der Realität immer der Fall sein dürfte), sind diese Solarzellen mittels elektrischer Leiter miteinander verschaltet.

Die Solarzelle 10 befindet sich in einem Gehäuse. Das Gehäuse weist einen Rahmen 40 auf. Der Rahmen 40 kann im Wesentlichen aus Aluminiumprofilen bestehen. Der Rahmen 40 stellt in der Abbildung 1 die Seitenwände des Gehäuses dar. Auf derjenigen Seite des Gehäuses, die dazu bestimmt ist, der elektromagnetischen Strahlung 2 der Sonne zugewandt angeordnet zu werden, befindet sich eine Abdeckung 20. Die Abdeckung umfasst eine Glasscheibe, insbesondere Einscheiben-Sicherheitsglas. Befinden sich mehrere Solarzellen in dem Gehäuse, bedeckt die Abdeckung vorteilhafterweise alle sich in dem Gehäuse befindlichen Solarzellen. Auf der Innenseite der Glasscheibe ist eine elektrochrome Schicht aufgebracht. Die elektrochrome Schicht bedeckt den gesamten der Solarzelle 10 zugewandten Bereich der Glasscheibe. Die elektrochrome Schicht ist mittels elektrischer Leiter 31 mit einer auf dem Boden des Gehäuses platzierten Steuerungseinheit 30 verbunden. Die Steuerungseinheit 30 ist dazu ausgestaltet, durch Anlegen einer elektrischen Spannung an die elektrochrome Schicht den Transmissionsgrad der elektrochromen Schicht für elektromagnetische Strahlung 2 in einem definierten Wellenlängenbereich zu steuern.

Somit enthält die Anordnung 1, die die Solarzelle 10, die Abdeckung 20 mit der elektrochromen Schicht und die Steuerungseinheit zur Steuerung der elektrochromen Schicht umfasst, einen "schaltbaren optischen Filter", der gezielt Photonen aus einem bestimmten Wellenlängenbereich blockieren bzw. durchlassen kann. Durch eine gezielte, temporäre Anpassung des Transmissionsgrads bestimmter Wellenlängenbereich kann damit einer Überhitzung der Solarzelle entgegengewirkt werden, ohne damit mehr Einbußen in der Energieausbeute der Solarzelle als unbedingt nötig hinnehmen zu müssen.

### Bezugszeichenliste

- 1: Anordnung
- 2: Elektromagnetische Strahlung

- 10: Solarzelle
- 101: Absorber
- 102: Vorderseitenkontakt
- 103: Rückseitenkontakt

- 20: Abdeckung

- 30: Steuerungseinheit
- 31: Elektrischer Leiter

- 40: Rahmen

## Patentansprüche

1. Anordnung (1) umfassend eine Solarzelle (10) und eine Abdeckung (20), wobei die Abdeckung (20) die Solarzelle (10) zumindest auf derjenigen Seite bedeckt, die zur Bestrahlung mit elektromagnetischer Strahlung (2) der Sonne vorgesehen ist,
**dadurch gekennzeichnet, dass**
die Abdeckung (20) eine elektrochrome Schicht und die Anordnung (1) ferner eine Steuerungseinheit (30) zur Steuerung der elektrochromen Schicht aufweist, wobei die Steuerungseinheit (30) dazu ausgestaltet ist, durch Anlegen einer elektrischen Spannung an die elektrochrome Schicht den Transmissionsgrad der elektrochromen Schicht für elektromagnetische Strahlung (2) in einem definierten Wellenlängenbereich zu steuern.

2. Anordnung (1) nach Anspruch 1,
wobei ein Steuern des Transmissionsgrads ein diskretes oder stufenloses Variieren des Transmissionsgrads der elektrochromen Schicht beinhaltet.

3. Anordnung (1) nach einem der vorhergehenden Ansprüche, wobei die Steuerungseinheit (30) dazu imstande ist, die Transmission von Photonen, die eine Energie aufweisen, die mehr als ein vorbestimmter Wert über der Aktivierungsenergie der Solarzelle (10) liegt, zu reduzieren oder im Wesentlichen zu unterdrücken.

4. Anordnung (1) nach einem der vorhergehenden Ansprüche, wobei die Steuerungseinheit (30) dazu imstande ist, die Transmission von Photonen, die eine Energie aufweisen, die mehr als ein vorbestimmter Wert unter der Aktivierungsenergie der Solarzelle (10) liegt, zu reduzieren oder im Wesentlichen zu unterdrücken.

5. Anordnung (1) nach einem der vorhergehenden Ansprüche, wobei die Steuerungseinheit (30) dazu imstande ist, jegliche Transmission von elektromagnetischer Strahlung (2) der Sonne durch die elektrochrome Schicht im Wesentlichen zu unterdrücken.

6. Anordnung (1) nach einem der vorhergehenden Ansprüche, wobei der Steuerungseinheit (30) die für ihren Betrieb benötigte elektrische Energie von der Solarzelle (10) bereitgestellt wird.

7. Anordnung (1) nach einem der vorhergehenden Ansprüche, wobei die Solarzelle (10) einen Absorber (101) zur Absorption der elektromagnetischen Strahlung (2) der Sonne aufweist und der Absorber (101) eine Perowskit-Struktur aufweist.

8. Anordnung (1) nach einem der vorhergehenden Ansprüche, wobei die Anordnung (1) mindestens eine weitere Solarzelle aufweist und die Solarzelle (10) und die weitere Solarzelle eine Tandemsolarzelle bilden.

9. Anordnung (1) nach einem der vorhergehenden Ansprüche, wobei die Abdeckung (20) eine Glasscheibe, insbesondere ein Einscheiben-Sicherheitsglas, aufweist.

10. Anordnung (1) nach einem der vorhergehenden Ansprüche, wobei die Anordnung (1) ferner einen die Abdeckung (20) umgebenden Rahmen (40) zur Befestigung und Versteifung der Abdeckung (20) aufweist.

11. Verfahren zum Betreiben einer Solarzelle (10), wobei die Solarzelle (10) mit einer Abdeckung (20) geschützt ist, wobei die Abdeckung (20) die Solarzelle (10) zumindest auf derjenigen Seite bedeckt, die zur Bestrahlung mit elektromagnetischer Strahlung (2) der Sonne vorgesehen ist, und wobei die Abdeckung (20) eine elektrochrome Schicht aufweist, das Verfahren umfassend ein Anlegen einer elektrischen Spannung an die elektrochrome Schicht mittels einer Steuerungseinheit (30), um den Transmissionsgrad der elektrochromen Schicht für elektromagnetische Strahlung (2) in einem definierten Wellenlängenbereich zu steuern.

12. Verfahren nach Anspruch 11,
wobei in einem vorherigen Schritt die Temperatur der Solarzelle (10) ermittelt wird und die Steuerung des Transmissionsgrads in Abhängigkeit von der ermittelten Temperatur der Solarzelle (10) erfolgt.

13. Verfahren nach Anspruch 12,
wobei es sich bei der Solarzelle (10) insbesondere um eine Solarzelle (10) mit einem Absorber (101), der eine Perowskit-Struktur aufweist, handelt, und die Temperatur der Solarzelle (10) mittels Impedanzspektroskopie ermittelt wird.
